# EUROPÄISCHE PATENTANMELDUNG

(11) **EP 1 160 973 A2**
(43) Veröffentlichungstag der Anmeldung: **05.12.2001**
(21) Anmeldenummer: 01810377.0
(22) Anmeldetag: 17.04.2001
(51) Int. Cl.: H03H 7/38

(54) **Terminierung für ein Mittelspannungskabel und Verfahren zur Signalübertragung**

(30) Priorität: 29.05.2000 DE 1002660
(71) Anmelder: ABB RESEARCH LTD., 8050 Zürich (CH)
(72) Erfinder: Lehmann, Josef, 79761 Waldshut-Tiengen (DE); Sabbattini, Bruno, 5430 Wettingen (DE); Doser, Bernhard, 79761 Waldshut (DE)
(74) Vertreter: ABB Patent Attorneys

(57) **Zusammenfassung**

Ein Signal in einem Frequenzbereich oberhalb 500 kHz wird über ein Mittelspannungskabel (1, 2) mit einzeln abgeschirmten Phasen (3) übertragen. Um Abstrahlungen und Störungen im Bereich einer Unterstation zu vermieden, sind Hochfrequenz-Terminierungen (5) vorgesehen. Jede Terminierung umfasst eine Induktionsanordnung (7) zum Abblocken des Frequenzbereichs, sowie einen Koppler (9, 10) zum Ein- bzw. Auskoppeln des Signals. Es zeigt sich, dass auf diese Weise Signale hoher Bandbreite über Mittelspannungskabel übertragen werden können, ohne dass es zu unerwünschten elektromagnetischen Abstrahlungen kommt.

## Beschreibung

### Technisches Gebiet

Die Erfindung betrifft eine Hochfrequenz-Terminierung für ein Mittelspannungskabel, eine Verwendung dieser Terminierung sowie ein Verfahren zur Signalübertragung über ein Mittelspannungskabel gemäss Oberbegriff der unabhängigen Ansprüche.

Als Hochfrequenz-Terminierung wird der hochfrequente Abschluss eines Mittelspannungskabels verstanden, inklusive einer Ein- bzw. Auskopplungsvorrichtung für hochfrequente Signale. Als Mittelspannung sind elektrische Spannungen (Phase zu Phase) von 6 kV - 36 kV zu verstehen.

### Stand der Technik

Heutzutage wird angestrebt, Stromversorungskabel zur Signalübertragung zu verwenden. Insbesondere für Hoch- und Niederspannungskabel wurden dabei bereits beträchtliche Datenraten erreicht. Ein Problem, das sich bei Übertragungen dieser Art jedoch stellt, sind unerwünschte elektromagnetische Abstrahlungen in Frequenzbereichen, die anderen Anwendungen vorbehalten sind.

### Darstellung der Erfindung

Es stellt sich die Aufgabe, eine Hochfrequenz-Terminierung bzw. ein Verfahren der eingangs genannten Art bereitzustellen, welche es ermöglichen, ohne allzu grossen Aufwand hohe Datenübertragungsraten zu erreichen, ohne dass unerwünschte Streufelder entstehen.

Diese Aufgabe wird von den unabhängigen Ansprüchen gelöst.

Insbesondere wird also eine Terminierung für ein Mittelspannungskabel bereitgestellt, die ein Induktionsglied und einen Koppler aufweist. Das Induktionsglied dient zum Abblocken von Frequenzen in einem Frequenzbereich oberhalb 500 kHz. Dieser Frequenzbereich kann also z.B. nach oben an 500 kHz anschliessen, oder er kann z.B. auch in einem Bereich von einigen MHz liegen. Vorzugsweise ist er irgendwo im Bereich zwischen 500 kHz und 30 MHz. Der Koppler dient dazu, im genannten Frequenzbereich Signale aus- oder einzukoppeln.

Erfindungsgemäss wird auch ein Verfahren bereitgestellt, bei welchem in einem Mittelspannungskabel mit einzeln abgeschirmten Phasen ein Signal mit einer Frequenz oberhalb 500 kHz übertragen wird. Dabei wird an den Enden des Mittelspannungskabels eine Terminierung zum Abblocken und Aus- bzw. Einkoppeln des Signals angeordnet.

Es zeigt sich, dass es möglich ist, in Mittelspannungskabeln mit einer derartigen Terminierung Daten mit hoher Bandbreite zu übertragen, ohne dass unerwünschte Abstrahlungen entstehen. Dies ist insbesondere eine Folge davon, dass heute gebräuchliche Mittelspannungskabel des Hochstädter-Typs für die einzelnen Phasen individuelle Abschirmungen aufweisen. Diese Abschirmungen sind zwar nicht zur Unterdrückung hochfrequenter Streufelder vorgesehen, sondern dienen dazu, die Feldstärken im Isolationsmaterial des Kabels zu steuern. Sie sind jedoch durchaus auch in der Lage, Streufelder sowie ein Übersprechen zwischen den Phasen im genannten Frequenzbereich zu unterdrücken.

Bisher wurden Mittelspannungskabel ohne Terminierungen verwendet, und im Mittelspannungsbereich wurden allenfalls Steuersignale im Bereich zwischen 40 kHz und wenigen hundert kHz übertragen. Bekannte Systeme bieten für Standard-Telekommunikationsanwendungen zuwenig Bandbreite.

Ein Kern ist nicht auf jeden Fall erforderlich, vorzugsweise besitzt das Induktionsglied der Terminierung jedoch eine Spule mit Kern, wobei der Kern ausserhalb der Spule geschlossen ist. Dadurch wird bei kompakter Bauweise eine hohe Induktivität erreicht. Um allzu hohe Magnetflüsse im Kern zu vermeiden, kann mindestens ein Spalt vorgesehen werden. Mittels geeigneter Abstimmungsmechanik kann die Breite des Spalts variiert werden, um das Induktionsglied abzustimmen.

Das Induktionsglied besitzt vorzugsweise eine Spule und ist mit einem Abstimmungsnetzwerk, z.B. einem Kondensator, parallel geschaltet. Das Abstimmungsnetzwerk kann dabei entweder von den Kapazitäten zwischen den Windungen der Spule gebildet werden, oder von mindestens einem zusätzlichen Bauteil, vorzugsweise von mehreren, in Serie angeordneten Einzelkondensatoren.

Vorzugsweise wird das Induktionsglied aus einem einstückigen, durch Fräsen oder Gusstechnik herstellbaren, formstabilen Metallkörper gebildet. Ein derartiger Körper kann mit höherer Präzision als ein Wickelkörper hergestellt werden, weshalb seine Eigenschaften besser reproduzierbar und stabiler sind.

In einer besonders bevorzugten Ausführung wird das Induktionsglied und gegebenenfalls das Abstimmnetzwerk in einem durchschlagfesten Medium angeordnet, insbesondere in einem festen Dielektrikum, oder einem Öl oder Isoliergas, wie z.B. SF₆. Dadurch kann die Terminierung sehr kompakt realisiert werden. Besonders vorteilhaft ist ein festes Dielektrikum, da dieses dem Induktionsglied mechanischen Halt vermittelt und Verformungen im Kurzschlussfall vermeidet.

### Kurze Beschreibung der Zeichnungen

Weitere Ausgestaltungen, Vorteile und Anwendungen der Erfindung ergeben sich aus den abhängigen Ansprüchen und aus der nun folgenden Beschreibung anhand der Figuren. Dabei zeigen:
Fig. 1 ein vereinfachtes Schaltbild für die Terminierung zweier Mittelspannungskabel bei einer Unterstation mit Signalein- und -auskoppler und mit Transponder bzw. Repeater,
Fig. 2 eine erste Ausführung einer Terminierung, wobei das Gehäuse im Schnitt und die Komponenten in Seitenansicht dargestellt sind,
Fig. 3 einen Schnitt durch die Terminierung nach Fig. 2,
Fig. 4 ein Ersatzschaltbild der Terminierung,
Fig. 5 eine zweite Ausführung einer Terminierung,
Fig. 6 einen Schnitt durch die Terminierung nach Fig. 5,
Fig. 7 eine dritte Ausführung einer Terminierung,
Fig. 8 einen Schnitt durch die Terminierung nach Fig. 5,
Fig. 9 ein Ersatzschaltbild für die dritte Ausführung der Terminierung und
Fig. 10 ein Kabel des Hochstädter-Typs.

### Wege zur Ausführung der Erfindung

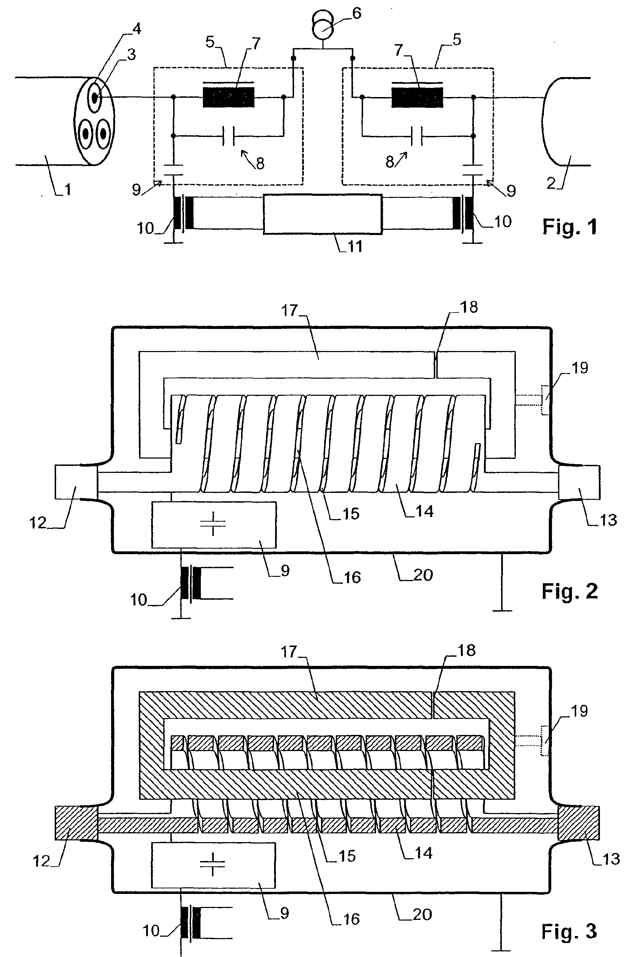

Fig. 1 zeigt schematisch den Aufbau einer Unterstation für zwei Mittelspannungskabel 1, 2. Jedes dieser Kabel ist vom heute gebräuchlichen Hochstädter-Typ, bei welchem die einzelnen Phasen 3 je einzeln von einem Metallschirm 4 umgeben sind.

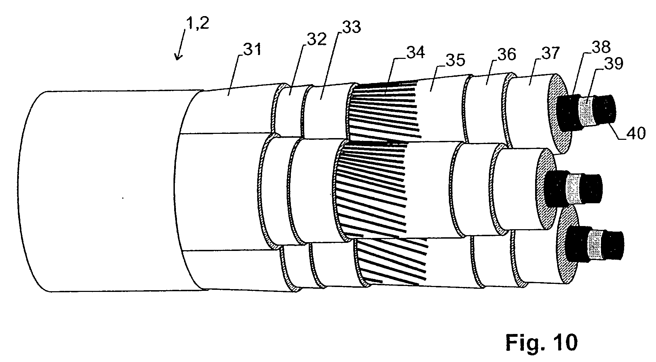

Der Aufbau einer möglichen Ausführung eines derartigen Kabels ist in Fig. 10 dargestellt. Es besitzt eine bis drei Phasen, die alle gleich aufgebaut sind und folgende Teile aufweisen: Eine äussere Isolation 31 aus PE, eine Kupferfolie 32 zum Schutz gegen Wasserdiffusion, eine Zwischenschicht 33 auf PE, einen Kupferdrahtschirm 34, zwei isolierende Schichten 35, 36, eine XPLE-Isolation 37, einen Leiter-Schirm 38, eine innere Kupferfolie 39 und den leitenden Kupferkern 40.

Wie aus Fig. 1 ersichtlich, ist mindestens eine der Phasen über je eine Terminierung 5 mit einem Transformator 6 verbunden. Aufgabe dieser Terminierung ist es, Signale in einem vorgegebenen Frequenzbereich vom Transformator fernzuhalten und über einen spannungsfesten Koppler aus der Phase auszukoppeln bzw. in die Phase einzukoppeln. Hierzu besitzt jede Terminierung 5 ein Induktionsglied 7, welches in Serie zum Mittelspannungskabel 1 bzw. 2 liegt. Parallel zum Induktionsglied 7 liegt eine Kapazität 8. Der Koppler umfasst in der ersten Ausführung vorzugsweise einen Koppelkondensator 9 und einen Übertrager bzw. Koppeltransformator 10. Der Koppeltransformator 10 ist mit einem Repeater oder Transponder 11 verbunden.

Der Frequenzbereich der durch die Mittelspannungskabel 1, 2 übertragenen Signale liegt oberhalb von 500 kHz. Die einzeln abgeschirmten Kabel des sogenannten Hochstädter-Typs bzw. mehrfach abgeschirmte Kabel erlauben eine Eindämmung der erzeugten Störfelder auf ein Mass, welches unter dem maximal erlaubten Pegel liegt. Lediglich im Bereich der Unterstationen bzw. der Regionen mit Abgängen muss das hochfrequente Signal durch zusätzliche Hilfsmittel in Form von Terminierungen auf ein tolerierbares Mass reduziert werden.

Dank der relativ hohen Frequenz und dem im folgenden beschriebenen Aufbau können die Terminierungen kompakt aufgebaut werden. Mögliche Ausführungen des Aufbaus werden im folgenden beschrieben.

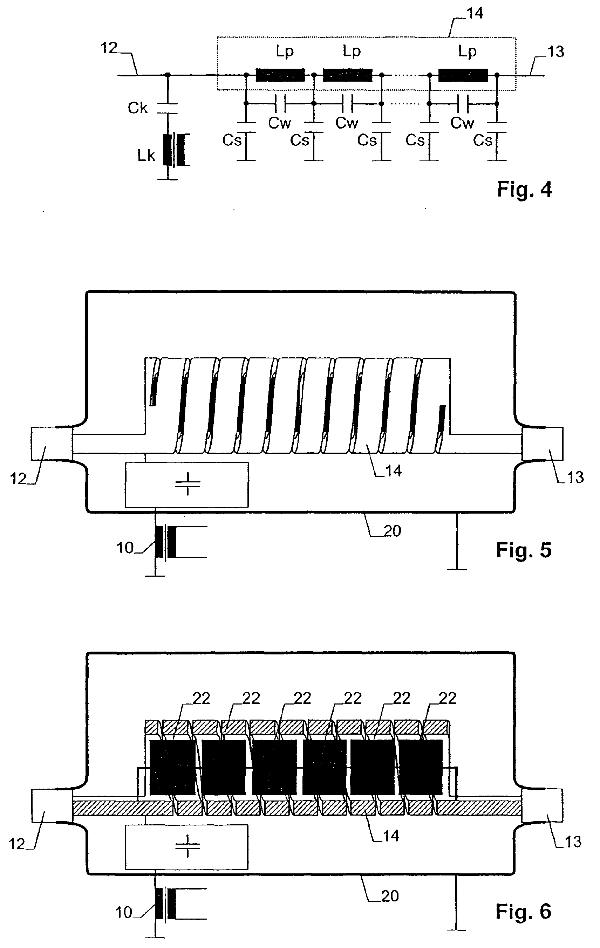

Eine erste Ausführung ist in Fig. 2 und 3 dargestellt. Sie besitzt einen Eingang 12 und einen Ausgang 13 für die Phase der Mittelspannung, wobei die entsprechenden Anschlüsse wie in EP 987 810 A1 beschrieben ausgeführt sein können.

Zwischen Ein- und Ausgang 12 bzw. 13 ist eine Spule 14 angeordnet, welche das Induktionsglied 7 bildet. Die Spule 14 kann aus einem hohlzylindrischen Metallkörper bestehen, in den ein wendelförmiger Schlitz 15 eingefräst wurde. Typische Abmessungen sind z.B. ein Aussendruchmesser von 100 mm, ein Innendurchmesser von 60 mm, eine Länge von 300 mm, eine Ganghöhe von 21 mm und eine Schlitzbreite von 3 mm. Die Spule 14 ist formstabil und kann dank der Verwendung von Frästechniken oder anderen erosiven Techniken oder mittels Gusstechnik mit hoher Genauigkeit gefertigt werden. Da die Spule nur eine Windungslage besitzt, ist sie kapazitätsarm.

Durch die Spule 14 erstreckt sich ein Kern 16, welcher über eine Rückführung 17 ausserhalb der Spule 14 geschlossen ist. Der Kern 16 besteht aus einem Ferrit-Material mit einer Grenzfrequenz von mindestens 30 MHz.

Damit bei hohen Strömen durch die Spule 14 der Magnetfluss im Kern nicht zu hoch wird, muss für heutzutage erhältliche ferritische Materialien mindestens ein Luftspalt 18 vorgesehen werden. Da die Breite der Spalte 18 einen Einfluss auf die Induktivität der Spule 14 hat, kann sie zum Abstimmen der Terminierung verwendet werden. Hierzu kann z.B. auch eine geeignete Abstimmungsmechanik 19 vorgesehen sein, um die beiden Teile des Kerns 16 gegeneinander zu bewegen und damit die Spaltbreite zu ändern.

Das ferritische Material des Kerns sollte eine obere Grenzfrequenz von mindestens 30 MHz besitzen. Je nach Einsatzort und den Eigenschaften der verwendeten Kommunikationstechnologie können auch Materialien mit wesentlich geringeren Grenzfrequenzen Verwendung finden.

Die Terminierung umfasst weiter den bereits erwähnten Koppelkondensator 9 und den Koppeltransformator 10. Ferner weist sie ein Gehäuse 20 aus Metall auf. Das Gehäuse 20 umschliesst die Spule 14 in definiertem Abstand. Es ist mit der Erde verbunden, wobei die Verbindung zur Erde eine definierte Erdungsinduktivität besitzt. Das Gehäuse 20 kapselt die Terminierung und schliesst alle spannungsführenden Teile ein.

Das Innere des Gehäuses ist mit einem nicht gezeigten, durchschlagfesten Medium ausgefüllt, um elektrische Festigkeit zu erreichen. Vorzugsweise handelt es sich dabei um ein festes Dielektrikum, das der Spule 14 im Kurzschlussfall mechanischen Halt verleiht. Es ist auch denkbar, ein flüssiges Dielektrikum, wie z.B. Öl, oder ein Schutzgas, wie z.B. SF₆ zu verwenden. Zur Erhöhung der Kurzschlussfestigkeit können weiter Distanzisolierstoffe zwischen die Windungen der Spule 14 eingebracht werden.

Fig. 4 zeigt ein Ersatzschaltbild für die Terminierung. Dabei bezeichnen Ck und Lk die Impedanzen, die den Eingang 12 mit Masse verbinden. Sie werden in erster Linie durch den Koppelkondensator 9 und den Koppeltransformator 10 bestimmt. Die elektrischen Eigenschaften der Spule 14 sind für jede Windung einzeln modelliert, wobei Lp die Induktivität jeder Windung und Cw die Kapazitäten zwischen den Windungen bezeichnen. Die Kapazitäten Cs zwischen den Windungen und der Masse bzw. dem Gehäuse sind ebenfalls zu berücksichtigen.

Für ein definiertes Frequenzverhalten der Terminierung ist es wichtig, dass die in Fig. 4 dargestellten Grössen bekannt und möglichst genau definiert sind. Dies wird in erster Linie dadurch erreicht, dass die Spule 14 eine hohe mechanische Stabilität und Genauigkeit besitzt. Dabei ist auch von Vorteil, dass für die Kapazitäten Cw keine speziellen Kondensatoren benötigt werden, da sie direkt von den Windungen der Spule 14 gebildet werden.

Eine zweite Ausführung der Erfindung ist in Fig. 5 und 6 dargestellt. Hier besitzt die Spule 14 keinen Kern. Deshalb muss ein Abstimmnetzwerk bzw. eine Kondensatoranordnung Cp parallel zur Spule 14 angeordnet werden, wobei mehrere, in Serie geschaltete Tuning-Kondensatoren 22 zwischen Eingang 12 und Ausgang 13 vorgesehen sind. Durch die Serieschaltung mehrerer Kondensatoren wird die notwendige Spannungsfestigkeit erreicht.

Alternativ zu den Tuning-Kondensatoren 22 kann ein anderes geeignetes Abstimmnetzwerk aus R, L und C-Gliedern verwendet werden. Derartige Netzwerke sind dem Fachmann bekannt.

Ansonsten ist die Ausführung nach Fig. 5 und 6 wie die erste Ausführung aufgebaut.

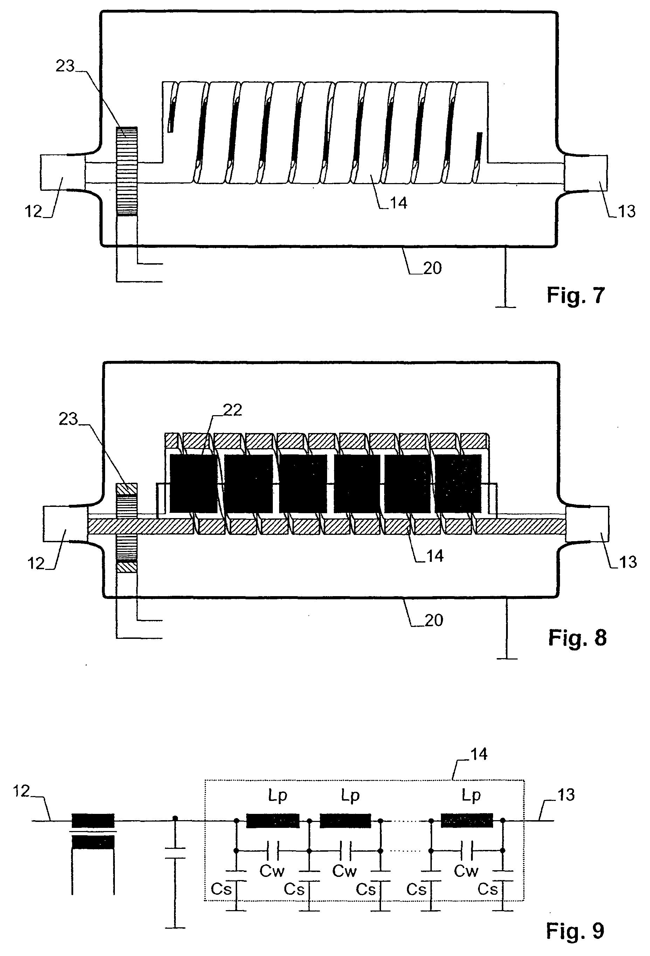

Eine dritte Ausführung der Erfindung ist in Fig. 7 - 9 dargestellt. Hier besteht der Koppler aus einer Ringkernspule 23, welche die Signale im Kabel induktiv ein- bzw. auskoppelt. Dadurch kann auf den Koppelkondensator 9 und den Koppeltransformator 10 verzichtet werden, die Kopplung ist nun jedoch davon abhängig, wie das Mittelspannungskabel über die Erde rückgeführt ist, was eine erhöhte Abhängigkeit vom momentanen Schaltzustand mit sich bringt.

Anstelle der kapazitiven Kopplung kann auch in den Ausführungen nach Fig. 2 und 3 sowie 5 und 6 die induktive Kopplung gemäss Fig. 7 und 8 eingesetzt werden.

In all den oben genannten Ausführungsbeispielen ist auf eine sichere Ausführung der Isolation zu achten. Vorzugsweise ist die Terminierung gekapselt, d.h. die auf Mittelspannung stehenden Teile sind vom Dielektrikum und Gehäuse eingeschlossen und gegen aussen isoliert.

### Bezugszeichenliste

- 1, 2:: Mittelspannungskabel
- 3:: Phasen
- 4:: Schirm
- 5:: Terminierung
- 6:: Transformator
- 7:: Induktionsglied
- 8:: Kapazität/Abstimmnetzwerk
- 9:: Koppelkondensator
- 10:: Koppeltransformator/Übertrager
- 11:: Transponder/Repeater
- 12:: Eingang der Terminierung
- 13:: Ausgang der Terminierung
- 14:: Spule
- 15:: Spalt zwischen den Windungen
- 16:: Kern
- 17:: Rückführung des Kerns
- 18:: Spalt
- 19:: Abstimmungsmechanik
- 20:: Gehäuse
- 22:: Tuning-Kondensatoren/Abstimmnetzwerk
- 23:: Ringkernspule

## Patentansprüche

1. Hochfrequenz-Terminierung für ein Mittelspannungskabel, **gekennzeichnet durch** ein Induktionsglied (7) zur Serieschaltung mit dem Mittelspannungskabel (1, 2), wobei das Induktionsglied (7) ausgestaltet ist zum Abblocken von Frequenzen in einem Frequenzbereich oberhalb 500 kHz, und weiter **gekennzeichnet durch** einen Koppler (9, 10; 23) zum Aus- und/oder Einkoppeln von Signalen aus der bzw. in das Mittelspannungskabel (1, 2) im besagten Frequenzbereich.

2. Hochfrequenz-Terminierung nach Anspruch 1, **dadurch gekennzeichnet, dass** das Induktionsglied (7) eine Spule (14) mit einem Kern (16) aufweist, wobei sich der Kern (16) durch die Spule (14) erstreckt und eine Rückführung (17) ausserhalb der Spule (14) aufweist, und insbesondere, dass zur Reduktion des Magnetflusses im Kern (16) mindestens ein Spalt (18) angeordnet ist, und insbesondere dass sie eine Abstimmungsmechanik (19) aufweist, mit welcher der Spalt (18) änderbar ist.

3. Hochfrequenz-Terminierung nach einem der vorangehenden Ansprüche, **dadurch gekennzeichnet, dass** der Frequenzbereich in einem Bereich zwischen 500 kHz und 30 MHz liegt.

4. Hochfrequenz-Terminierung nach einem der vorangehenden Ansprüche, **dadurch gekennzeichnet, dass** das Induktionsglied (7) als Spule (14) ausgebildet ist, und dass parallel zum Induktionsglied ein Abstimmnetzwerk vorgesehen ist,
und insbesondere dass das Abstimmnetzwerk eine Kapazität (Cw, Cp) parallel zum Induktionsglied (7) aufweist, wobei die Kapazität entweder von Streukapazitäten (Cw) zwischen den Windungen der Spule (14) oder von mehreren, zueinander in Serie angeordneten Einzelkondensatoren (22) gebildet wird.

5. Hochfrequenz-Terminierung nach einem der vorangehenden Ansprüche, **dadurch gekennzeichnet, dass** der Koppler (9, 10; 23) ausgestaltet ist zur kapazitiven und/oder induktiven Ankopplung an das Mittelspannungskabel.

6. Hochfrequenz-Terminierung nach einem der vorangehenden Ansprüche, **dadurch gekennzeichnet, dass** das Induktionsglied (7) eine Spule (14) aus einem einstückigen, durch wendelförmiges Fräsen oder in Gusstechnik herstellbaren, formstabilen Metallkörper ist.

7. Hochfrequenz-Terminierung nach Anspruch 6, **dadurch gekennzeichnet, dass** der Metallkörper in einem Dielektrikum eingeschlossen ist.

8. Hochfrequenz-Terminierung nach einem der vorangehenden Ansprüche, **dadurch gekennzeichnet, dass** das Induktionsglied (7) in Gehäuse (20) gekapselt ist, wobei das Metallgehäuse (20) vorzugsweise geerdet ist.

9. Verwendung der Terminierung nach einem der vorangehenden Ansprüche zur Signalübertragung über ein Mittelspannungskabel mit abgeschirmten Leitern.

10. Verfahren zur Signalübertragung über ein Mittelspannungskabel, **dadurch gekennzeichnet, dass** im Mittelspannungskabel (1, 2) ein Signal mit einer Frequenz oberhalb 500 kHz übertragen wird, wobei das Mittelspannungskabel (1, 2) einzeln abgeschirmte Phasen (3) besitzt, und dass an den Enden des Mittelspannungskabels (1, 2) eine Terminierung (5) zum Abblocken und zum Ausbzw. Einkoppeln des Signals angeordnet wird.
